# EUROPEAN PATENT SPECIFICATION

(11) **EP 2 859 573 B1**
(45) Date of publication and mention of the grant of the patent: **28.02.2018**
(21) Application number: 13744816.3
(22) Date of filing: 11.06.2013
(51) Int. Cl.: H01J 3/02, H01J 37/077, H01J 37/34, H01J 37/32

(54) **DEVICE FOR GENERATING PLASMA AND DIRECTING AN ELECTRON BEAM TOWARDS A TARGET**
VORRICHTUNG ZUR PLASMAERZEUGUNG UND LENKUNG EINES ELEKTRONENSTRAHLS AUF EIN ZIEL
DISPOSITIF POUR GÉNÉRER UN PLASMA ET DIRIGER UN FAISCEAU D'ÉLECTRONS VERS UNE CIBLE

(30) Priority: 11.06.2012 IT BO20120320
(43) Date of publication of application: 15.04.2015
(73) Proprietor: Noivion S.r.l., 38068 Rovereto (Trento) (IT)
(72) Inventor: Skocdopolova, Libuse, I-40129 Bologna (IT)
(74) Representative: Ponchiroli, Simone
(86) International application number: PCT/IB2013/054765
(87) International publication number: WO 2013/186697

(56) References cited:
- WO-A1-2012/025947
- FR-A- 1 374 245
- FR-A1- 2 498 010
- US-B2- 7 183 564

## Description

### Technical field

This invention relates to a device for generating plasma and directing an electron beam towards a target, as well as applications of said device.

In particular, an apparatus and a method are provided for the application of a layer of material on a support and an apparatus and a method for welding.

### Background art

There are various types of devices designed to act as sources of electrons and of plasma. Some such devices use the emission of electrons induced by a strong electric field or the thermal emission of a heated line (these sources may be identified as being of the "field emission" or "thermal emission" types). The generation and conveying of the electron beam often occurs in an environment with an ultra-high vacuum. In such cases the electrons do not make impact with the atoms of the residual gas and have a very narrow energy spectrum. However, the density of the beam must be kept relatively low because the spatial charging effect must be low enough to avoid spatial and energy dispersion of the electron packet with consequent reduction of the intensity and the monochromaticity. Another family of electron sources uses a "virtual" cathode based on the presence of a plasma from whose surface electrons are emitted. The formation of this plasma cathode requires a residual gas pressure which is relative high (up to 0.1 mbar). In that case the propagation of the electron beam is accompanied by the generation of secondary plasma caused by the impact of the electrons against the atoms of the residual gas. Such impacts cause on one hand energy dispersion from the electrons, and on the other hand intensification of the electron beam by means of the secondary emission of electrons from the gas atoms. The presence of the secondary plasma also creates an electrostatic shield effect which allows the electron packet to travel in such a way that it is compact without spatially dispersing. Therefore, the electron beam, even if polydisperse in terms of energy, may have a charging density which is decidedly higher than with "field emission" or "thermal emission" sources.

There are many methods for generating a plasma cathode as an electron source: "glow discharge" (for example described in WO2012/025947 or US7183564), "steady state DC discharge" (for example described in H. Goktas, Hulya Kirkici, G. Oke, and M. V. Udrea, leee Transactions On Plasma Science, Vol. 30, No. 5, (2002), 1837; and in Efim M. Oks and Peter M. Schanin; Phys. Plasmas 6, (1999), 1649), arc discharge (for example described in WO 2010/109297 A2), and even a type of Penning discharge (for example described in G. E. Ozur, S. A. Popov, V. F. Fedushchak, and A. V. Saushkin; Technical Physics Letters, Vol. 32, (2006), pages 928-931), covering at least the basic operating principles. Even the propagation and multiplication of the electron beam from the cathode to the anode and beyond as far as the target can be carried out in various ways, creating two main classes of electron sources. In a first class the electron beam is propagated in the free space on the "background" of the stationary residual gas with the pressure balanced in the entire space of the vacuum chamber containing the source of electrons (H. Goktas, Hulya Kirkici, G. Oke, and M. V. Udrea, leee Transactions On Plasma Science, Vol. 30, No. 5, (2002), 1837; and in Efim M. Oks and Peter M. Schanin; Phys. Plasmas 6, (1999), 1649). In contrast, in the second class a capillary tube made of dielectric material is used to guide the electron beam (in the sector the term "capillary tube" refers to a tube with a diameter of between 1.5 and 4 mm. Outside said size range, the system no longer works because a capillary tube with a diameter of less than 1.5 mm has excessive impedance which does not allow the plasma to propagate inside it, whilst a capillary tube with a diameter greater than 4 mm does not allow a sufficient plasma density to be maintained, the consequence being a reduction in the quantity of electrons generated (and therefore in ablation efficiency for said use). Said capillary tube is often filled by the flow of residual gas at a pressure higher than the rest of the vacuum chamber, thereby forming a pressure and density gradient. Such a technique is often referred to as "channel spark discharge" (US7183564; WO 2010/109297 A2; and G. E. Ozur, S. A. Popov, V. F. Fedushchak, and A. V. Saushkin; Technical Physics Letters, Vol. 32, (2006), pages 928-931).

The first class of sources can operate either with continuous emission, or in pulse mode. The second class, using the capillary tube, is almost always operated in pulse mode to avoid the potential problem of it overheating. In fact, acting on the duty cycle of the pulses it is possible to keep the mean power transmitted by the capillary tube relatively low so as to avoid damaging its inner surface with overheating.

Sources of electrons with free propagation of the beam suffer from problems of directing and dispersion of the electron packet. In contrast, sources equipped with the capillary tube are limited in terms of the mean energy of the electrons due to the inner ablation of the capillary tube which in turn causes contamination of the target material. Moreover, since the capillary tube imposes stringent geometric conditions on the shape of the source, the capillary tube itself constitutes an obstacle to industrial "scaling-up" of the system.

It should also be noticed that when capillary tubes are used, the electron beam contains impurities (deriving from the capillary tubes) and regular maintenance and substitution of these components is necessary (they tend to get dirty and inhibit the capacity of the device for generating the electron beam) with even very brief periods of action (from a few hours to a few days).

### Disclosure of the invention

This invention has for an aim to provide a device for generating plasma, apparatuses comprising said device and methods using said device, which allow the disadvantages of the prior art to be at least partly overcome and which at the same time are easy and inexpensive to make and implement. This invention also has for an aim to provide a device for generating plasma, apparatuses comprising said device and methods using said device which have as many of the advantages as possible and as few of the disadvantages as possible of each prior art alternative. Accordingly, this invention provides a device for generating plasma, an apparatus comprising said device and a method using said device as described in the independent claims below and, preferably, in any of the claims directly or indirectly dependent on the independent claim.

### Brief description of the drawings

This invention is described below with reference to the accompanying drawings, which illustrate several non-limiting embodiment, in which:
Figure 1 is a schematic illustration partly in cross-section of an apparatus which can be used in a method according to this invention;
Figures 2 to 8 are schematic illustrations partly in cross-section of further embodiments of the apparatus of Figure 1.

### Detailed description of preferred embodiments of the invention

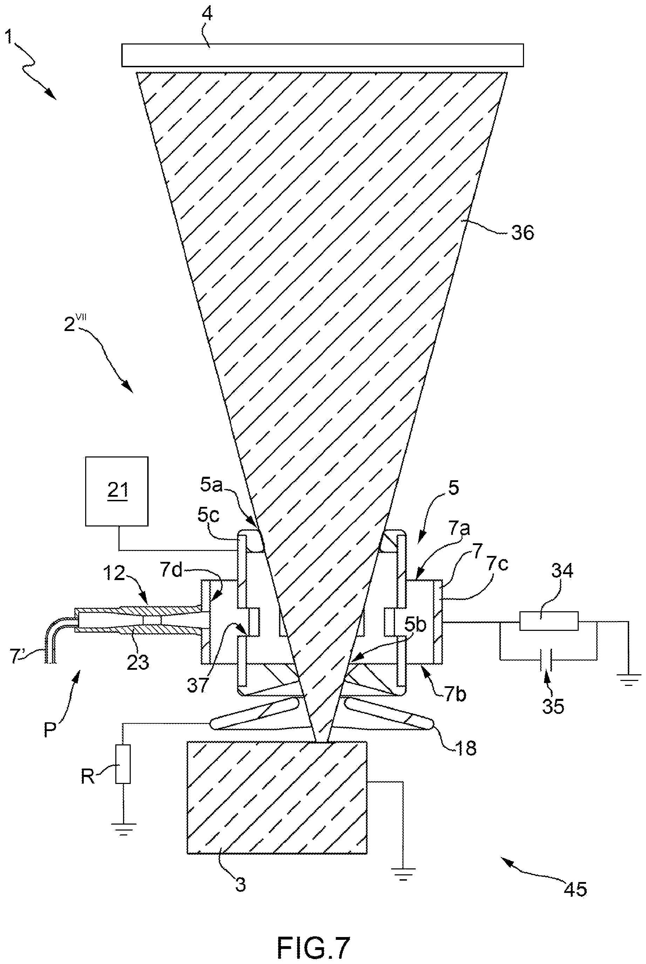

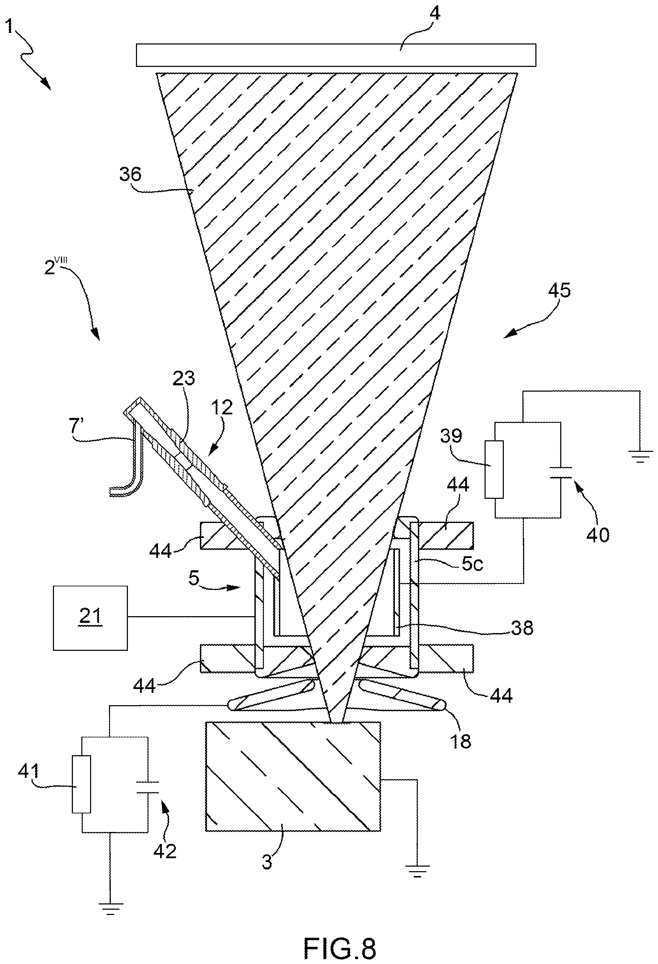

The following is a description of various embodiments of this invention which must be understood to all be suitable for independent protection even by means of the filing of any separate patent applications. Regarding the embodiments in Figures 7 and 8 it shall be understood that the variants without the acceleration channel may also be the subject of possible independent protection.

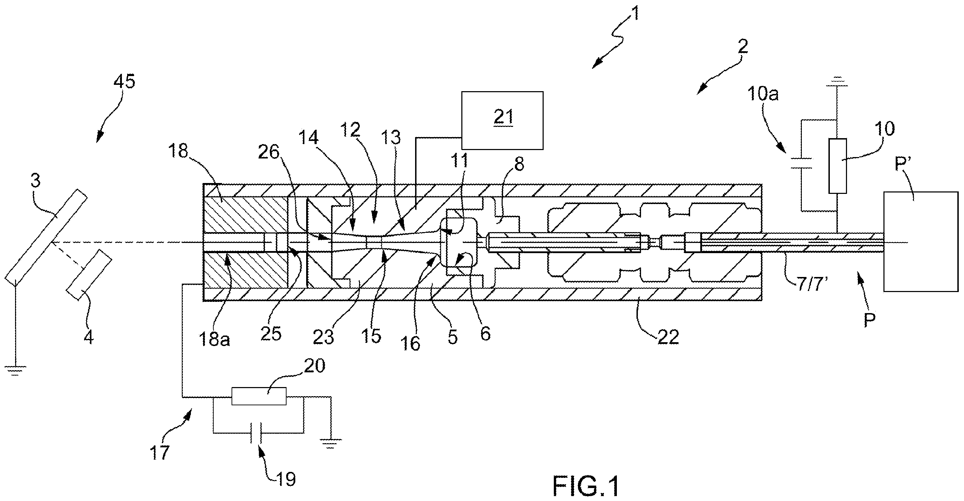

In Figure 1, the numeral 1 denotes in its entirety an apparatus for depositing a predetermined material. The apparatus 1 comprises a device 2 for generating plasma (that is to say, an at least partial ionisation of a rarefied gas) and for directing an electron beam towards a target 3, which comprises (in particular is constituted of) the predetermined material, in such a way that at least part of the predetermined material is separated from the target 3 and is deposited on a support 4.

According to alternative embodiments, the predetermined material may be composed of a single homogeneous material or of a combination of two or more different materials.

Advantageously, the target 3 is earthed. In this way, the target 3 does not repel (and rather attracts) the electron beam even when the electrons have already struck the target 3.

The device 2 comprises a hollow element 5, designed to act as a cathode and comprising (externally delimiting) an interior cavity 6. The device 1 also comprises a trigger electrode 7, which comprises (in particular, is constituted of) an electrically conducting material (in particular, metal). The trigger electrode 7 is positioned inside the cavity 6 (delimitated by the hollow element 5). In particular, the hollow element 5 comprises (more in particular, is constituted of) an electrically conducting material (more particularly, a metal material). The trigger electrode 7 comprises (more particularly, is constituted of) an electrically conducting material (more particularly, a metal material).

In particular, the term electrically conducting material refers to a material having an electrical resistivity (measured at 20°C) of less than 10⁻¹ Ohm m. Advantageously, the electrically conducting material has an electrical resistivity (measured at 20°C) of less than 10⁻³ Ohm m.

In some embodiments, the hollow element 5 comprises (in particular is constituted of) a material selected from the group consisting of: Tungsten, Molybdenum, pyrolytic graphite (and a combination of them). In some embodiments, the trigger electrode 7 comprises (in particular is constituted of) a material selected from the group consisting of: Tungsten, Molybdenum, stainless steel, copper, pyrolytic graphite (and a combination of them).

According to the embodiment illustrated in Figure 1, the trigger electrode 7 extends through a wall 8 of the hollow element 5. Interposed between the trigger electrode 7 and the wall 8 there is a ring (not illustrated) of substantially electrically insulating material (in particular Teflon, glass, quartz, ceramic).

In particular, the term substantially electrically insulating material refers to a material which has an electrical resistivity (measured at 20°C) which is greater than 10³ Ohm m. Advantageously, the material which does not conduct electricity has an electrical resistivity (measured at 20°C) which is greater than 10⁷ Ohm m (more advantageously, greater than 10⁹ Ohm m). According to some embodiments, the substantially electrically insulating material is a dielectric material.

The device 2 also comprises a resistor 10, which connects the trigger electrode 7 to earth and has a resistance of at least 100 Ohm, advantageously of at least 1 kOhm. In particular, the resistor 10 has a resistance of around 20 kOhm.

In other embodiments, in place of the resistor 10 another electronic device with equivalent function is used.

Advantageously, a capacitor 10a is positioned (in parallel with the resistor 10) between the trigger electrode 7 and earth. The capacitor 10a has a capacitance of between 0.5 nF and 10 nF, advantageously between 1 nF and 5 nF. According to specific embodiments, the capacitor 19 has a capacitance of around 3 nF.

Inside the cavity 6 there is a rarefied gas. According to some embodiments, the cavity 6 contains the rarefied gas at a pressure which is less than or equal to a 5x10⁻² mbar (in particular, less than 10⁻² mbar). In particular, the rarefied gas contained in the cavity 6 has a pressure greater than or equal to 10⁻⁵ mbar (more particularly, greater than or equal to 10⁻⁴ mbar).

Relative to this, it should be noticed that the device 2 comprises a pressure regulation system P, designed to define (maintain) the above-mentioned pressure inside the cavity 6. Advantageously, the regulation system P is designed to define (maintain) inside the cavity 6 a pressure which is greater than that on the outside (outer chamber 45). In particular, the pressure regulation system P is designed to define (maintain) inside the cavity 6 a pressure at least 10 times (in some cases, at least 15 times) greater than the pressure on the outside.

More precisely, on the outside (where a rarefied gas is present - according to some embodiments, anhydrous) a pressure greater than or equal to 10⁻⁶ mbar is maintained. In some cases, on the outside a pressure less than or equal to 10⁻⁵ mbar is maintained.

The pressure regulation system P comprises a gas supply unit for supplying the gas (advantageously, anhydrous) inside the cavity 6 (so as to increase its pressure compared with the outside of the device, in any case always inside the depositing chamber). In particular, the gas supply unit comprises a duct 7' which enters the cavity 6 and a pressure source P' (for example a pump). It should be noticed that, in the embodiment illustrated, in Figure 1 the duct 7' also acts as the trigger electrode 7 (as described above). In other words, the duct 7' and the trigger electrode 7 coincide.

In some embodiments, the regulation system P comprises a fast-opening and -closing valve, usually a valve able to open and/or close in less than 100 microseconds, especially in less than 500 nanoseconds. In this way it is possible to produce the plasma in pulse mode, without the need to manage rapid pulses in the application of the differences in potential described below.

The gas present in the cavity 6 and on the outside (in the outer chamber 45) is substantially the same. II gas is, advantageously, anhydrous.

In some embodiments, the gas is substantially inert.

In some cases, the gas is selected from the group consisting of: oxygen, nitrogen, argon, NO, helium, xenon, hydrogen (and a combination of them).

According to some embodiments, the gas is Argon and if necessary oxygen in the amount of 0% to 10% (by volume compared with the total volume of the gas). Alternatively, the gas is Argon and up to 1% (by volume compared with the total volume of the gas) of a further element selected from the group consisting of: H₂, He, N₂.

The hollow element 5 comprises an opening 11 for putting the cavity 6 in fluid communication with the outside.

The device 2 also comprises an acceleration channel 12 for accelerating the movement of what is contained in the cavity 6 through the opening 11 towards the outside. More precisely, the acceleration channel is designed to accelerate what is contained in the cavity 6 towards the target 3 (in particular, towards an element of interaction 18).

The acceleration channel 12 comprises at least one (continuously) tapered portion 13. In particular, the portion 13 is tapered towards the outside.

The acceleration channel 12 also comprises a portion 14 located downstream of the portion 13 relative to the cavity 6 (and to the opening 11). Advantageously, said portion 14 is (continuously) tapered towards the portion 13.

In other words, the acceleration channel 12 forms a de Laval nozzle. According to the embodiment illustrated, the portion 13 substantially has a frustoconical shape. The portion 14 substantially has a frustoconical shape.

In particular, the portion 13 comprises an extremity 15 facing towards the outside (and therefore towards the portion 14) with a passage area (that is to say a canal or free cross-section) of at least approximately 14 mm². Said passage area is up to approximately 25 mm². More precisely, said passage area is from approximately 17 mm² to approximately 22 mm² (in particular, approximately 20 mm²).

The portion 13 comprises an extremity 16 facing towards the cavity 6 with a passage area of at least 300 mm² (in particular, at least 350 mm²).

Said passage area is up to approximately 2000 mm².

The acceleration channel 12 is located between the cavity 6 and the outside. In particular, the cavity 6 is in fluid communication with the outside through the acceleration channel 12.

It should be noticed that the acceleration channel 12 comprises an extremity (specifically the extremity 16) facing the opening 11.

The device 2 also comprises a stabilisation unit 17, which, in turn, comprises an element of interaction 18, which is located outside the hollow element 5.

The element of interaction 18 comprises (in particular, is constituted of) an electrically conducting material (metal). Advantageously, said material has a melting point higher than 1300°C.

According to some embodiments, said material is selected from the group consisting of: steel (in particular stainless), Tungsten, Molybdenum, Chromium, pyrolytic graphite (and a combination of them). In particular, the element of interaction 18 comprises (is constituted of) a material selected from the group consisting of: Tungsten, Molybdenum, pyrolytic graphite (and a combination of them).

The stabilisation unit 17 also comprises a capacitor 19 electrically connected to the element of interaction 18 and to earth.

The tapered portion 13 is tapered towards the element of interaction 18 (and is designed to accelerate the movement of what is contained in the cavity towards the element of interaction 18).

Advantageously, the capacitor 19 has a capacitance which is less than the capacitance of a capacitor (electrically) connected to the hollow element 5. In particular, said capacitor has a capacitance which is at least double the capacitance of the capacitor 19.

More specifically, the capacitor 19 has a capacitance of between 0.5 nF and 10 nF, advantageously between 1 nF and 5 nF. According to specific embodiments, the capacitor 19 has a capacitance of around 3 nF.

In contrast, in other embodiments, in place of the capacitor 19 another electronic device with equivalent function and if possible the same capacitance is used.

The stabilisation unit also comprises a resistor 20, which connects the element of interaction 18 to earth. In particular, the resistor 20 is positioned in parallel with the capacitor 19.

According to some embodiments, the resistor 20 has a resistance of at least 1 kOhm and, advantageously, up to 1 MOhm. In particular, the resistor 20 has a resistance of from approximately 5 to approximately 10 kOhm.

In contrast, in further embodiments, in place of the resistor 20 another electronic device is used, having equivalent function and if possible the same resistance.

The element of interaction 18 comprises a passage channel 18a whose passage area is greater than (or equal to) the passage area of one end 26 of the acceleration channel 12 (in particular, of the portion 14) opposite to the cavity 6 (that is to say, opposite to the opening 11).

The device 2 also comprises an activation group 21 designed to impose a difference in potential between the hollow element 5 and the element of interaction 18. The activation group 21 is (also) designed to impose a potential difference between the hollow element 5 and the trigger electrode 7.

In some embodiments, the activation group 21 is like the activation group described in the patent applications with publication numbers WO2010/109297, WO 2011/148251 and/or in applications PCTIT2011000301, PCTIB2011054182 (see in particular, the activation group 11 described in these patent applications).

In particular, the activation group 21 is designed to cause a reduction (in particular, starting from an electrical potential substantially equal to zero) in the electrical potential of the hollow element 5 of at least 2kV (in particular, at least 6 kV). More precisely, the activation group 21 causes a reduction in the electrical potential of the hollow element 5 of at least 12kV (in particular, at least 18kV). The activation group 21 causes a reduction in the electrical potential of the hollow element 5 of up to 25kV (in particular, up to 24kV; more precisely up to 20kV). The reduction in the electrical potential of the hollow element 5 occurs in less than 1000 ns, particularly in less than 20 ns. In particular, that is done by directing a pulse of electrical charge of at least 0.16 mC (up to 0.5 mC) towards the hollow element 5. Advantageously, the activation group 21 is designed to impose the reduction in potential on the hollow element 5 in less than 15 ns (more precisely, in less than 10 ns); in some cases, in less than approximately 4 ns. In this way, the plasma is created (inside the hollow element 5). It should be noticed that hereinafter the entire space in which the plasma is developed (which in the case just described corresponds at least to the cavity 6) will be referred to in its entirety as the generation space. Therefore, in use, the activation group 21 imposes a potential difference between the hollow element 5 and the trigger electrode 7 according to the parameters described above. As a result, the plasma is generated (that is to say, there is at least partial ionisation of the rarefied gas) inside the cavity 6.

When electrons formed in the cavity 6 enter the acceleration channel 12, the difference in potential, established with the element of interaction 18, allows the electrons to be accelerated along the acceleration channel 12 towards the target 3. During their movement, these electrons strike further molecules of gas and therefore cause the emission of secondary electrons which, in turn, are accelerated towards the target 3.

In addition to that, it should be noticed that the gas contained in the cavity 6 enters the acceleration channel 12 (de Laval nozzle) and fills it. At this point, said gas, passing through the acceleration channel 12 (due to the special geometric configuration of the acceleration channel 12) is accelerated. The transversal degrees of freedom of the molecules of gas are transformed into the motion parallel with the axis of the acceleration channel 12. The molecules pass through the element of interaction 18 (along the passage channel 18a) and continue on their journey towards the target 3. In its entirety, the system is advantageously structured in such a way that it is in the conditions on the left of the minimum of the Paschen curve (F. Paschen, Wied. Ann., 37 (1889) 69), so that the greater density of the gas in the jet of gas accelerated (in the acceleration channel 12) relative to the adjacent space causes preferred electrical discharge between the hollow element 5 (which acts as a cathode) and the element of interaction 18 (which acts as an anode) inside the jet itself, preventing electrical discharge between the other parts of the system. In this way, the parts of the system are less worn and the electron beam has a relatively low quantity of impurities. Moreover, in this way discharge is not triggered outside the device 1 (that is to say, outside the acceleration channel 12).

The gas of the jet is ionised by the discharge between the hollow element 5 and the element of interaction 18, the electrons and the plasma propagate in this area and beyond the element of interaction 18 towards the target 3 (therefore, the entire plasma formation zone is part of what was called the generation space). At this point, the element of interaction 18 changes role, acting as a cathode (since in the meantime its stray capacitance charged fully to the cathode potential carried by the ionisation front) and the target 3 acts as an anode. The electrons of the plasma are accelerated by the difference in potential between the element of interaction 18 and the target 3. Said electrons strike the target 3 causing it to melt or its ablation.

Since the target 3 acts as an anode, it is advantageous that the target 3 is connected to earth (with a wire suitable for withstanding high electrical current pulses which are greater than or equal to 1 kA). In this way, the target 3 does not repel (and rather attracts) the electron beam even when the electrons have already struck the target 3. Moreover, in this embodiment there is no need for the target 3 to be made of conducting material, that is to say, the target 3 may be made of insulating and/or dielectric material.

Advantageously the target 3 is connected to earth without a resistor being interposed. In other words, the target 3 is connected to earth with the least possible resistance.

The intensity and efficiency of the pulse of electrons which are accelerated onto the target can be controlled either by altering the pulse of the potential which is supplied to the hollow element 5 or by modifying the capacitance of the capacitor 19, gas pressure, distance between the acceleration channel 12 and the target 3.

The device 2 also comprises a tubular element 22 (sleeve) made of a substantially insulating material (as defined above - usually glass). Said tubular element 22 allows structural stability to be achieved between the hollow element 5 and the element of interaction 18. According to some embodiments not illustrated, the tubular element 22 is absent.

The tubular element 22 is made of a substantially insulating material (as defined above). According to some embodiments, the tubular element 22 is made of dielectric material, advantageously glass or ceramic.

The device 2 also comprises an operator interface unit (of the know type and not illustrated), which allows an operator to adjust operation (for example use and/or editing of operating parameters) of the device 2. When operating in such a way as to create a sequence of pulses of electrons, the frequency of the pulses must be selected based on various elements including the intended use (for example if one intends to perform an ablation or welding) and the type of target 3 (for example considering the type of material used to make the target 3). In some situations, (the plasma is generated and) the electron beam is direct towards the target 3 with a frequency of at least 2 Hz (in some cases, at least 30 Hz; more precisely, at least 100 Hz).

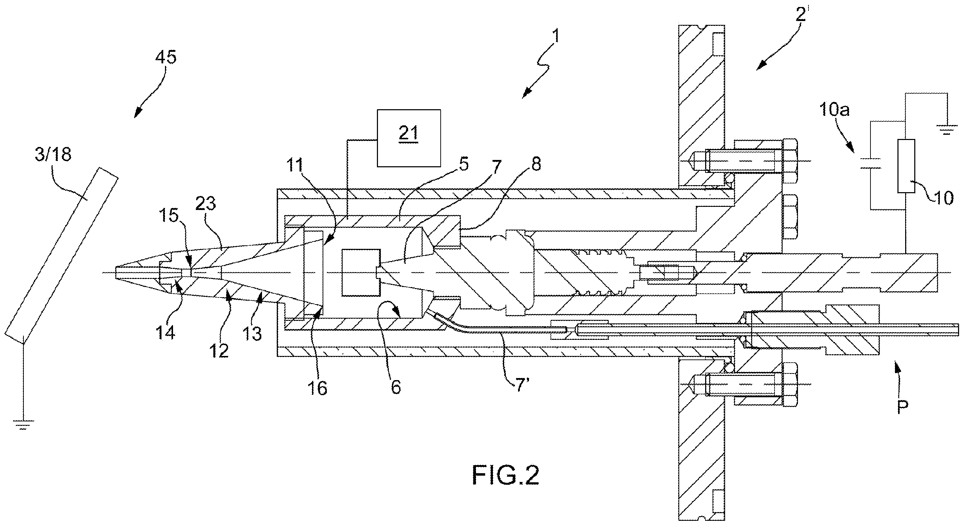

Figure 2 shows a further embodiment of the device 2 labelled 2'. The device 2' differs from the device 2 in terms of geometric aspects (the same elements but with different shapes). The device 2' also comprises a trigger electrode 7 and a duct 7' which are different parts (that is to say they do not coincide).

Moreover, the device 2' does not have the element of interaction 18. More precisely, in this case the functions performed by the element of interaction 18 are carried out by the target 3. In other words, the target 3 and the element of interaction 18 coincide. Whilst (in contrast), in the device 2, the element of interaction 18 and the target are different parts (that is to say, they do not coincide).

Advantageously (in the device 2'), the target 3 is electrically connected to earth. The target 3 (moreover) is made of an electrically conducting material (such as that defined above for the element of interaction 7). Advantageously the target 3 is connected to earth without a resistor being interposed. In other words, the target 3 is connected to earth with the least possible resistance.

The target 3 and the connection to earth should, advantageously, be selected in such a way that they can withstand high pulses of electric current (of 1 kA or above).

The device 2' allows particular precision in directing the electron beam towards specific points of the target 3. In particular, it should be noticed that there is very little dispersion (transversally - widening) of the electron beam. It is thought that this is because of the fact that the electrons move in a sort of channel delimited by positive ions between the acceleration element 23 and the target 3.

The device 2' is particularly useful in cases in which (instead of ablation) one wants to perform welding.

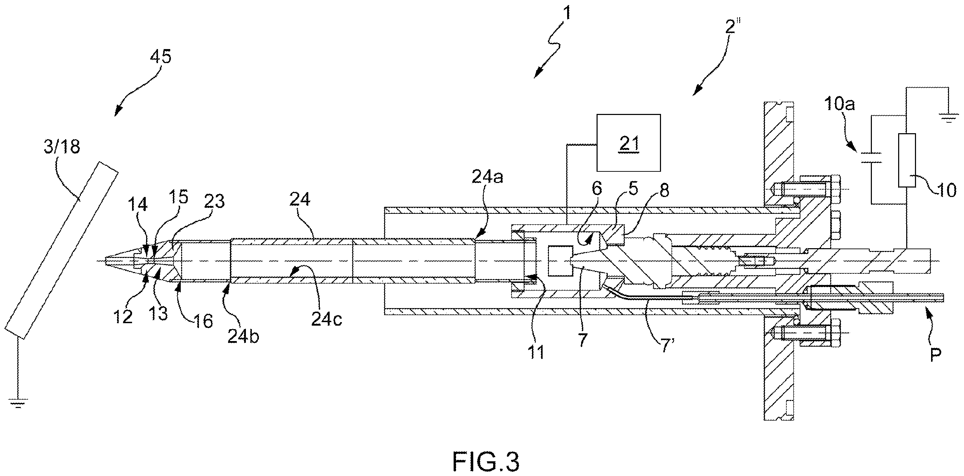

Figure 3 shows a further embodiment of the device 2 labelled 2". The device 2" basically differs from the device 2' due to the fact that located between the acceleration channel 12 (in particular, the acceleration element 23) and the hollow element 5 there is a tubular element 24. The tubular element 24 is designed to put the cavity 6 and the acceleration channel 12 in fluid communication.

The tubular element 24 comprises two open ends 24a and 24b and an interior canal 24c (which puts the cavity 6 in fluid communication with the acceleration channel 12). The tubular element 24 and the related interior canal 24c have respective substantially circular cross-sections.

The tubular element 24 is made of electrically insulating material (as defined above). According to some embodiments, the tubular element 24 is made of dielectric material, advantageously glass, quartz or ceramic.

It was observed during experiments that the density of the electrons, which are generated inside the hollow element 5 - acceleration element 23 system and which are transported by the jet of gas towards the target 3, depends on the density of the plasma created inside the hollow element 5. Said density is controlled by various parameters (for example: the pressure of the gas inside the cavity 6, the electric current supplied to the plasma generated, the difference in potential which generates the plasma, etc.), but it may further be controlled by the geometry of the column of plasma inside the device itself.

Introducing the tubular element 24 the geometry of the column of plasma (the length and the cross-section) defines the inductance of the plasma and, therefore, the maximum value of the electric current carried inside the source of the plasma. In contrast, the current defines the temperature and the density of the plasma from which the quantity of electrons extracted from the plasma and supplied by the source is derived. Therefore, by modifying the length and cross-section (the diameter) of the tubular element 24 (more precisely of the related canal 24c) it is possible to regulate the current (in other words, the electron beam; that is to say, the number of electrons per unit of time) exiting the acceleration channel 12. More precisely, the smaller the passage area inside the tubular element 24 (that is to say, the smaller the cross-section of the canal 24c), the less current there is (the greater the resistance and inductance are); the shorter the tubular element 24 is, the greater the current is (the less the resistance and inductance are).

The possibility of regulating (in particular, increasing) the current exiting the acceleration channel 12 in a simple way (by changing the size of the tubular element 24) is a significant advantage compared with the prior art.

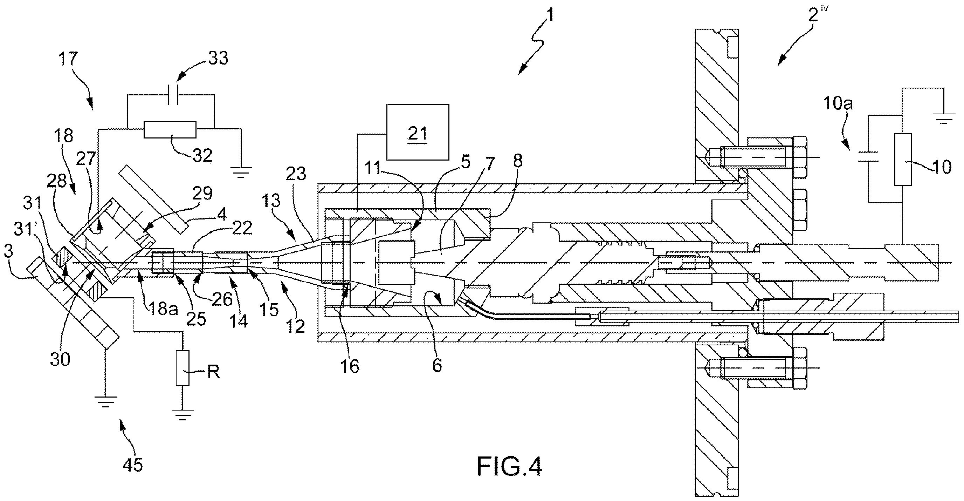

Figure 4 shows a further embodiment of the device 2 labelled 2^{IV}. The device 2^{IV} (differs from the device 2' because it) comprises an element of interaction 18 (in addition to the target 3). The element of interaction 18 comprises the passage channel 18a and is in fluid communication with the acceleration channel 12. The passage channel 18a comprises an inlet end 25 facing an outlet end 26 of the acceleration channel 12. The end 26 is opposite to the end 16.

The element of interaction 18 also comprises an interior chamber 27, which is in fluid communication with the passage channel 18a and is delimited laterally by at least one wall 28. The interior chamber 27 comprises two open ends 29 and 30. In particular, the interior chamber 27 extends between the ends 29 and 30 in a direction transversal to the direction in which the passage channel 18a extends. It should be noticed that the surface of the target 3 facing towards the element of interaction 18 is substantially perpendicular to the direction in which the chamber 27 extends between the ends 29 and 30.

In some embodiments, the interior chamber 27 has a substantially cylindrical shape.

According to the embodiment illustrated, the device 2^{IV} also comprises an additional electrode 31. Advantageously, the additional electrode 31 is earthed. In particular, the additional electrode is earthed by means of a resistor R. Usually this resistor R has a resistance of at least 100 Ohm, advantageously at least 1 kOhm. In particular, the resistor R has a resistance of approximately 20 kOhm.

Advantageously, the additional electrode 31 comprises an interior passage 31' which is delimited laterally. In use, the electron beam moves through the interior passage 31'. In particular, the additional electrode has a substantially annular shape.

In particular, the target 3 is directly earthed by a wire with the lowest possible resistance. Advantageously, in all of the embodiments illustrated, the target 3 is connected to earth without a resistor being interposed. In other words, the target 3 is connected to earth with the least possible resistance.

According to embodiments not illustrated, the additional electrode 31 is absent. In these cases, the target 3 is (directly) earthed (without resistors being interposed).

According to some embodiments, the element of interaction 18 is earthed. In particular, the element of interaction 18 is earthed through a resistor 32 (or equivalent means). This resistor 32 usually has a resistance of at least 100 Ohm, advantageously of at least 1 kOhm. In particular, the resistor 32 has a resistance of approximately 20 kOhm.

Advantageously, capacitive means 33 are also present (in particular, a capacitor). Said capacitive means 33 are connected in parallel with the resistor 32. The capacitive means 33 usually have a capacitance of between 0.5 nF and 10 nF, advantageously between 1 nF and 5 nF. According to specific embodiments, the capacitive means 33 have a capacitance of around 3 nF.

Advantageously (in particular, to guarantee mechanical stability), the acceleration element 23 and the element of interaction 18 are connected to one another by a tubular element 22 as defined above (although in this case it is mounted downstream of the acceleration element). According to some embodiments, said tubular element 22 is not present.

In use, the plasma and the electrons are produced by the interaction of the hollow element 5 (whose potential is suddenly made to fall, as previously specified for the device 2) with the trigger electrode 7. The plasma and the electrons are (also) conveyed thanks to the acceleration channel 12 towards the element of interaction 18. At this point, the system made up of the element of interaction 18 and the additional electrode 31 (and/or the target 3) acts as an electron extractor and accelerator which accelerates the electrons and conveys them towards the target.

The fact that the chamber 27 extends in a direction transversal to the outfeed direction of the electrons (and of the plasma) from the cavity 6, allows the electron beam to be made to strike with an optimum direction (usually perpendicularly) relative to the target 3. Based on what is indicated above, the efficiency of the impact of the electron beam on the target 3 is improved.

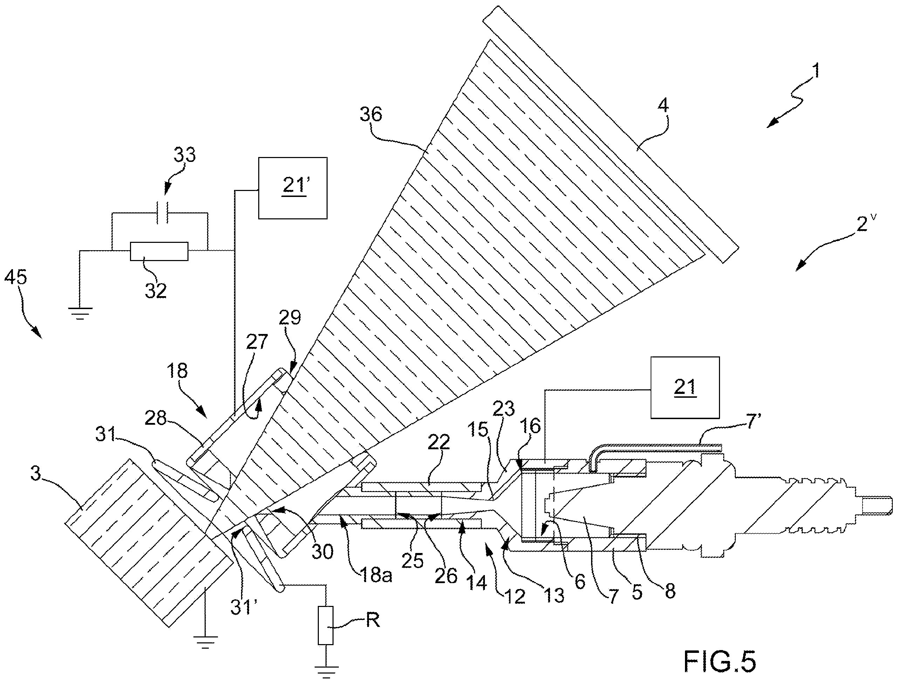

Moreover, in use, the plume 36 consisting of ablated material (the plume 36 is schematically illustrated in Figures 5 to 10) propagates in a direction perpendicular to the surface of the target 3, said direction extending through the open ends 29 and 30, towards the support 4. Again in this case the quality and efficiency of depositing is significantly improved. In that way, the material of the plume, propagating through the chamber of the element of interaction 18, is re-processed by the plasma present in said chamber. This effect has a positive influence on the quality of depositing, precisely affecting (reducing the value of) the particle size of the material deposited.

Due to the advantages indicated above, said special shape of the element of interaction 18, with the passage channel 18a transversal to the extension of the chamber 27, may also be advantageous in embodiments without the acceleration element. Therefore, it shall be considered a possible subject of independent protection by means of a separate application.

Figure 5 shows a further embodiment of the device 2 labelled 2^{V}. The device 2^{V} (differs from the device 2^{IV} due to the fact that it) comprises a further activation group 21' connected to the element of interaction 18. The structure and operation of the activation group 21' are similar to those of the activation group 21 and are designed to amplify the overall effect. However, the activation group 21' is designed to impose a negative potential on the element of interaction 18 which is lower in absolute value than the negative potential which the activation group 21' is designed to impose on the hollow element 5.

In use, the element of interaction 18 is brought to the negative potential (described above with reference to the hollow element 5 regarding the embodiment of Figure 1) continuously or using pulses (in the case of pulses, the pulse supplied to the element of interaction 18 must be synchronised with that supplied to the hollow element 5; in this case, the capacitive means 33 may be omitted). The system operates in the zone on the left of the minimum of the Paschen curve and, therefore, the system is stable relative to spontaneous sparking of the main discharge. The pulse of the negative potential in absolute value greater on the hollow element 5 sparks the electrical discharge between the cathode and the element of interaction 18 (thanks to the presence of the acceleration channel 12) through the tubular element 22 (the tubular element 22 mainly supports the mechanical stiffness of the system and may be substituted by free space). The plasma created in the cavity 6 propagates towards the element of interaction 18 and serves as an initiator of the process of creation of the plasma inside the element of interaction 18. The electrons contained in said plasma are extracted by the difference in potential between the element of interaction 18 and the additional electrode 31. The resistance between the additional electrode 31 and the ground (earth) potential limits the electric current diverted by the electron beam directed towards the target 3 by the additional electrode 31. Said resistance causes an increase in the negative potential on the additional electrode 31 during the electrical discharge between the element of interaction 18 and the target 3. Therefore, the additional electrode 31 becomes the virtual cathode for the system consisting of the additional electrode 31 and the target 3. The acceleration of the electrons occurs in the gap between the additional electrode 31 and the target 3. The high energy electrons ablate the material of the target and generate an explosive jet of plasma and of particles of the neutral material of the target which propagate towards the element of interaction 18 where they meet the plasma of the main discharge. The interaction between the two plasmas causes further ionisation of the plasma of the target 3 and disintegration and ionisation of the particles of the neutral material of the target 3 (which is directly earthed - without resistors interposed).

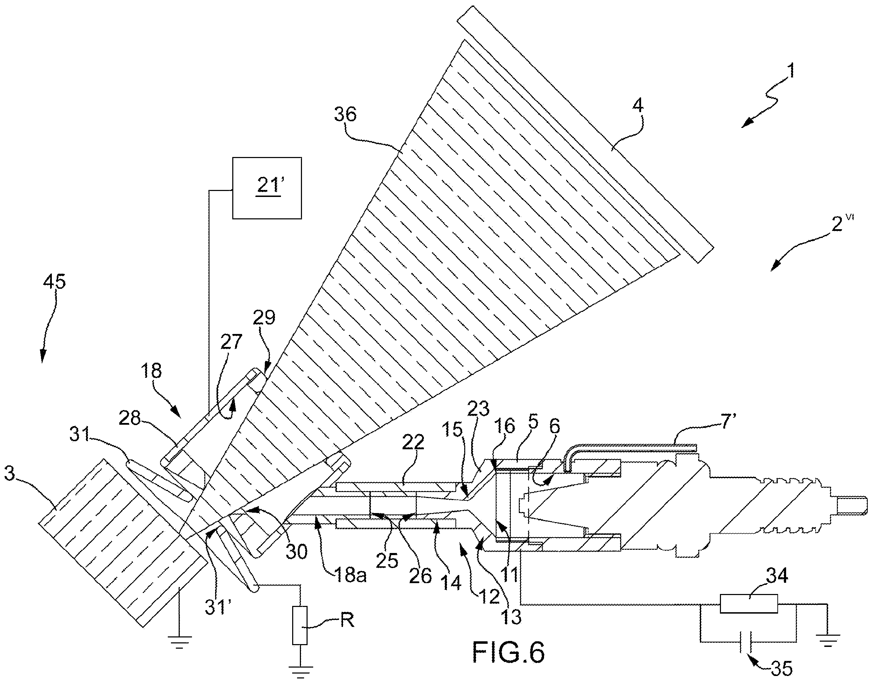

Figure 6 shows a further embodiment of the device 2 labelled 2^{VI}. The device 2^{VI} (differs from the device 2^{V} because it) does not comprise the activation group 21 connected to the hollow element 5. The hollow element 5 is earthed. In particular, the hollow element 5 is earthed through a resistor 34 (or equivalent means). This resistor 34 usually has a resistance of at least 100 Ohm, advantageously of at least 1 kOhm. In particular, the resistor 34 has a resistance of approximately 20 kOhm. Advantageously, there are also capacitive means 35 present (in particular, a capacitor). Said capacitive means 35 are connected in parallel with the resistor 34. The capacitive means 35 usually have a capacitance of between 0.5 nF and 10 nF, advantageously between 1 nF and 5 nF. According to specific embodiments, the capacitor 19 has a capacitance of around 3 nF.

Moreover, the device 2^{VI} does not have the resistor 32 and the capacitive means 33.

In this case, in use, the process of generating the plasma and the electron beam begins with the arrival of the pulse of negative potential at the element of interaction 18. The acceleration channel 12 and the difference in potential between the element of interaction 18 and the hollow element 5 pushes the electrons from the interior chamber 27 towards the hollow element 5 and rapidly charges the capacitive means 35. At this point, inside the element of interaction 18 (in the chamber 27) a positive potential is created relative to the wall 28 and the hollow cathode effect is induced amplifying the number of electrons present (the capacitive means 35 are already charged to the potential of the element of interaction, therefore, the electrons are no longer removed from the hollow element 5). The difference in potential between the element of interaction 18 and the additional electrode 31 (remember that, as said relative to the embodiment of Figure 4, the additional electrode 31 is electrically earthed through a resistor as defined above) removes and accelerates the electrons generated inside the element of interaction 18 towards the target 3 (which is directly earthed).

It should be noticed that the element of interaction 18 and the hollow element 5 act as trigger electrodes in the embodiment of Figure 6.

Figure 7 shows a further embodiment of the device 2 labelled 2^{VII}. The device 2^{VII} (differs from the device 2 because it) comprises the hollow element 5 inside the trigger electrode 7. The hollow element 5 comprises two open ends 5a and 5b. The hollow element 5 also comprises a lateral wall 5c which laterally delimits the cavity 6.

The trigger electrode 7 comprises two open ends 7a and 7b. The trigger electrode 7 also comprises a lateral wall 7c which delimits a passage 7d.

The hollow element 5 (in particular the lateral wall 5c) comprises at least one (in the case in question four - of which three are illustrated) openings 37. The openings 37 put the passage 7d in fluid communication with the cavity 6. In particular, in use, the electron beam passes through the openings 37. The difference in potential induced between the hollow element 5 and the trigger electrode 7 determines the formation of the plasma in the accelerated flow of gas exiting the acceleration channel 12 (which has a higher pressure - considering the Paschen curve).

In the embodiment illustrated, the hollow element 5 has a substantially annular shape (with circular cross-section). The trigger electrode 7 has a substantially annular shape (with circular cross-section).

Advantageously, the hollow element 5 and the trigger electrode 7 are substantially coaxial. In particular, the open ends 5a and 5b are facing in the same direction as the open ends 7a and 7b, respectively.

Moreover, the acceleration channel 12 (and therefore the acceleration element 23) is interposed between the gas supply unit (in particular, the duct 7') and the hollow element 5. In particular, the acceleration channel 12 (and therefore the acceleration element 23) is interposed between the gas supply unit (in particular, the duct 7') and the trigger electrode 7.

The device 2^{VII} also comprises the element of interaction 18.

According to some embodiments, the element of interaction 18 is earthed. In particular, the element of interaction 18 is earthed through a resistor 41 (or equivalent means).

Operation of the device 2^{VII} is similar to that described for the device 2 and is distinguished from the latter (in addition to what is said above) substantially due to the fact that the electron beam from the hollow element 5 to the target 3 does not pass through the acceleration channel 12. It should be noticed that, in any case, the electron beam passes through the element of interaction 18.

Although the device 2^{VII} can operate even without the acceleration element 23, experiments have shown that the presence of the acceleration channel 12 noticeably improves operation of the device 2^{VII}.

Figure 8 shows a further embodiment of the device 2 labelled 2^{VIII}. The device 2^{VIII} (differs from the device 2^{VII} because it) does not comprise the trigger electrode 7 and its does not comprise the openings 37.

The device 2^{VIII} comprises the hollow element 5 with the cavity 6 and the two open ends 5a and 5b. The cavity 6 is laterally delimited by the lateral wall 5c. The hollow element 5 has a substantially cylindrical (hollow) shape. In particular, the hollow element 5 has a substantially annular shape.

The hollow element 5 is electrically connected to the activation group 21 (as defined above).

The device 2^{VIII} also comprises a tubular element 38 (designed to act as a Penning anode, E. H. Hirsch, Br. J. Appl. Phys. 15 (1964) 1535).

According to some embodiments, the tubular element 38 is earthed. In particular, the tubular element 38 is earthed through a resistor 39 (or equivalent means). This resistor 39 usually has a resistance of at least 100 Ohm, advantageously of at least 1 kOhm. In particular, the resistor 34 has a resistance of approximately 20 kOhm. Advantageously, there are also capacitive means 40 present (in particular, a capacitor). Said capacitive means 40 are connected in parallel with the resistor 39. The capacitive means 40 usually have a capacitance of between 0.5 nF and 10 nF, advantageously between 1 nF and 5 nF. According to specific embodiments, the capacitor 19 has a capacitance of around 3 nF.

The tubular element 38 is positioned inside the hollow element 5 (in particular in the cavity 6). In particular, the tubular element 38 is substantially coaxial with the hollow element 5.

The device 2^{VIII} also comprises the element of interaction 18.

According to some embodiments, the element of interaction 18 is earthed. In particular, the element of interaction 18 is earthed through a resistor 41 (or equivalent means). This resistor 41 usually has a resistance of at least 100 Ohm, advantageously of at least 1 kOhm. In particular, the resistor 34 has a resistance of approximately 20 kOhm. Advantageously, there are also capacitive means 42 present (in particular, a capacitor). Said capacitive means 42 are connected in parallel with the resistor 41. The capacitive means 42 usually have a capacitance of between 0.5 nF and 10 nF, advantageously between 1 nF and 5 nF. According to specific embodiments, the capacitor 19 has a capacitance of around 3 nF.

The device 2^{VIII} also comprises the acceleration channel 12 (in particular, the acceleration element 23).

The acceleration channel 12 (as defined above) is designed to push anhydrous gas into the tubular element 38. The acceleration channel 12 (and therefore the acceleration element 23) is interposed between the gas supply unit (in particular, the duct 7') and the hollow element 5 (in particular, the tubular element 38).

The device 2^{VIII} also comprises at least one (in the case in question, two) sources 44 of magnetic field. In particular, the source 44 is designed to create a magnetic field in a direction of passage through the open ends 5a and 5b. In particular, the magnetic field should be substantially parallel with the axis of the element of interaction 18. The source 44 may be a permanent magnet or an electromagnetic source (comprising a coil along which a variable current is passed).

The source 44 produces the magnetic field parallel with the axis of the hollow element 5.

With the arrival of the negative potential pulse at the hollow element 5 through the activation group 21 a volume of plasma is created inside the tubular element 38 (Penning anode) which is at a potential slightly more positive than the potential of the hollow element 5, but substantially more negative than the potential of the Penning anode, creating an electrical potential gradient and therefore a radial electrical field (perpendicular to the axis of the hollow element 5). The source 44 produces the magnetic field parallel with the axis of the hollow element 5. In the crossed fields the electrons are accelerated radially from the centre of the system towards the Penning anode, performing precession around the lines of the magnetic field and producing a strong ionisation of the gas present. The element of interaction 18 is used to remove the electrons from the plasma created using the above-mentioned process.

Although the device 2^{VIII} can operate even without the acceleration element 23, experiments have shown that the presence of the acceleration channel 12 noticeably improves operation of the device 2^{VIII}.

The apparatus 1 therefore comprises at least one of the devices 2 - 2^{VIII} and one outer chamber 45, in which the target 3 and the support 4 are positioned. The conditions (for example pressure and type of gas contained) present in the outer chamber 45 are those described above with reference to the outside (of the device 2).

It should be noticed that, according to an aspect of this invention a method is provided for the application of the predetermined material on the support 4. The method comprises an emission step, during which at least one of the devices 2 - 2^{VIII} directs an electron beam against the target 3 comprising the predetermined material in such a way as to remove at least part of the predetermined material from the target 3 and direct it towards the support 4.

In addition to the advantages described above, all of the embodiments have various aspects which are improvements on the prior art.

It should be noticed, in particular, that the electron beam obtained has very low dispersion (it spreads very little transversally to the direction of travel). That not only improves the precision, but also allow a greater concentration of energy at predetermined points (increased intensity). Moreover, it should also be emphasised that, although in some embodiments the presence of a tubular element made of dielectric material (usually glass) is still proposed, the presence of said tubular element is not essential. The devices proposed (2 - 2^{VIII}) without glass capillary tubes can achieve (and even exceed) the performance of devices currently equipped with such capillary tubes.

In other words, according to what is described it is possible to avoid the use of glass capillary tubes. That allows:
- a reduction in production costs (capillary tubes used until now have considerable costs);
- a drop in the need for maintenance (glass capillary tubes had to be regularly substituted, both because they became dirty and because, being made of a relatively delicate material they became worn and/or broke);
- an increase in the frequency of the pulses (and therefore in the energy supplied to the target 3 in the unit of time - with glass capillary tubes high frequencies cannot be reached because the capillary tubes would melt).

As indicated above, what is illustrated in the accompanying drawings relates to an apparatus for depositing a predetermined material. However, it should be noticed that the device 2 - 2^{VIII} is (partly thanks to its advantages - indicated above - over the prior art) also suitable for other types of applications. With regard to this, it is important to underline that the device 2 - 2^{VIII} can also be used for welding.

Therefore, according to a further aspect of this invention a welding apparatus is provided. In this case, the apparatus is substantially the same as the apparatus 1 and differs from it structurally only in the absence of the support 4 and a different type of target 3.

In particular, the welding apparatus comprises at least one of the devices 2 - 2^{VIII}, an outer chamber 45, and target 3, which is located in the outer chamber 45 (and on which the welding is performed).

According to a further aspect of this invention a method for welding on the target 3 is also provided. The method comprises an emission step, during which at least one of the devices 2 - 2^{VIII} directs an electron beam against the target 3 (comprising the predetermined material) in such a way as to carry out the welding.

Unless explicitly otherwise indicated, the content of the references (articles, books, patent applications, etc.) indicated in this text is referred to in its entirety.

## Claims

1. A device for generating plasma and directing an electron beam towards a target (3); the device (2) comprising:
a hollow element (5), which has a cavity (6);
a generation space in which in use the plasma is developed;
an activation group (21), which is configured to in use impose a potential difference between the hollow element (5) and another element which is separate from the hollow element (5) so as to in use direct the beam of electrons from the generation space towards said other element which is separate from the hollow element (5)
the device (2) being **characterised in that** it comprises a channel of acceleration (12) in fluid communication with said generation space, and a pressure regulation system (P), which is configured to carry upstream of the acceleration channel (12) a pressure greater than a pressure downstream of the acceleration channel (12) for in use generating a gas flow both in the generation space and along the acceleration channel (12) in a direction from upstream to downstream of the self-same acceleration channel (12), and the acceleration channel (12) being configured to accelerate the movement of said gas flow.

2. The device according to claim 1, wherein the acceleration channel (12) has an axis of extension and is configured to transform any components of transversal motion of the gas molecules into a motion parallel with the self-same axis.

3. The device according to claim 1 or 2, wherein the acceleration channel (12) comprises at least one tapered portion (13) having a cross-section which decreases along the direction of the gas flow.

4. The device according to any one of the preceding claims, wherein the acceleration channel (12) comprises a de Laval nozzle.

5. The device according to any one of the preceding claims, also comprising an element of interaction (18) which is separate from the hollow element (5).

6. The device according to claim 5, wherein said other element which is separate from the hollow element (5) is the element of interaction (18).

7. The device according to any one of the claims from 1 to 5, wherein said other element which is separate from the hollow element (5) is the target (3).

8. The device according to any one of the preceding claims, wherein the generation space comprises said cavity (6).

9. The device according to claim 3 and any one of the other preceding claims, wherein the hollow element (5) comprises an opening (11), for putting in fluid communication the cavity (6) with the outside; the acceleration channel (12) being positioned between the separate element and the cavity (6), and being configured to accelerate the movement of the gas flow through the opening (11); the pressure regulation system (P) being configured to bring into the cavity (6) a pressure greater than that of the outside; the other element which is separate from the hollow element (5) being positioned outside the hollow element (5); the tapered portion (13) being tapered towards the other element which is separate from the hollow element (5) and being configured to accelerate the movement of the gas flow towards the other element which is separate from the hollow element (5).

10. The device according to any one of the preceding claims, and comprising a trigger electrode (7), which is at least partially placed within the cavity (6); the activation group (21) also being configured to impose a potential difference between the trigger electrode (7) and the hollow element (5) so that inside the cavity (6) electrons are formed; in particular, the activation group (21) is electrically connected to the hollow element (5) and is configured to reduce the electric potential of the hollow element (5) by at least 2kV in less than 40ns.

11. The device according to any one of the preceding claims, wherein the pressure regulation system (P) comprises a gas supply unit, configured to supply gas into the cavity (6) for maintaining in the cavity a pressure which is greater than that on the outside .

12. The device according to any one of the preceding claims, and comprising an acceleration element (23), which delimits the acceleration channel (12) and is directly connected to the hollow element (5).

13. The device according to any one of the claims from 1 to 11, and comprising an acceleration element (23), which delimits the acceleration channel (12) and is connected to the hollow element (5) by means of a tubular element (22) made of dielectric material interposed between them.

14. The device according to claim 5 and any one of the other preceding claims, wherein the element of interaction (18) comprises a passage channel (18a), in which, in use, the electron beam passes.

15. The device according to claim 14, wherein the passage channel (18a) comprises an inlet end (25) substantially facing an outlet end (26) of the acceleration channel (12).

16. The device according to claim 15, wherein the passage channel (18a) and the acceleration channel (12) are substantially mutually coaxial.

17. The device according to claim 14, 15 or 16, wherein the element of interaction (18) comprises an interior chamber (27) in fluid communication with the passage channel (18a) and delimited laterally; the interior chamber (27) comprising two open ends (29, 30) and extending between the open ends (29, 30) transversally relative to the passage channel (18a).

18. The device according to claim 5 or 6 **characterised in that** the element of interaction (18) comprises a passage channel (18a), inside which, in use, the electron beam passes and comprising an inlet end (25) facing towards the cavity (6) for in use receiving the electron beam, and an interior chamber (27) in fluid communication with the passage channel (18a) and delimited laterally; the interior chamber (27) comprising two open ends (29, 30) and extending between the open ends (29, 30) transversally relative to the passage channel (18a).

19. An apparatus for deposition of a predetermined material on a support (4), the apparatus (1) comprising:
an outer chamber (45) in which in use it is possible to place said support (4), on which the deposition takes place, and a target (3) comprising the predetermined material;
the apparatus (1) being **characterised in that** it comprises a device (2; 2'; 2"; 2^{IV}; 2^{V}; 2^{VI}; 2^{VII}; 2^{VIII}) as defined in one of the preceding claims, the cavity (6) of the device and the outer chamber (45) being in communication with one another; the outer chamber (45) containing gas at a pressure less than 10⁻³ mbar; the device (2; 2'; 2"; 2^{IV}; 2^{V}; 2^{VI}; 2^{VII}; 2^{VIII}) being configured to direct the electron beam against the target (3) so that at least part of the predetermined material is removed from the target (3) and is deposited on the support (4).

20. A method for the application of a predetermined material on a support (4), the method comprising an emission step, during which a device (2; 2'; 2"; 2^{IV}; 2^{V}; 2^{VI}; 2^{VII}; 2^{VIII}) according to any one of the claims from 1 to 18 directs said electron beam against a target (3) comprising the predetermined material so as to remove at least part of the predetermined material from the target (3) and direct it towards the support (4).

21. A method for generating an electron beam comprising the operating steps of:
filling a generation space and an acceleration channel (12) which communicates with it with a rarefied ionisable gas;
generating a flow of said gas through the generation space and the acceleration channel (12), and towards the outside;
accelerating the gas flow along an axis of the acceleration channel (12) and transforming any components of motion of the gas molecules transversal to the axis into a motion parallel with the self-same axis;
causing the formation of plasma in the generation space and at least partly in the accelerated gas flow; and
directing the electron beam from the plasma formed in this way towards a target (3).

22. The method according to claim 21, wherein the gas flow is generated in the direction towards the target (3).

23. The method according to claim 21 or 22, wherein the accelerated gas flow is used to guide the plasma and the electron beam.

## Patentansprüche

1. Ein Gerät zur Erzeugung von Plasma und zur Leitung eines Elektronenstrahls zu einem Ziel (3); wobei das Gerät (2) Folgendes umfasst:
ein Hohlelement (5), das einen Hohlraum (6) hat;
einen Erzeugungsraum, in dem das Plasma im Einsatz entwickelt wird;
eine Aktivierungsgruppe (21), die so konfiguriert ist, dass sie im Einsatz einen Potentialunterschied zwischen dem Hohlelement (5) und einem anderen Element, das vom Hohlelement (5) getrennt ist, erzeugt, um den Elektronenstrahl im Einsatz vom Erzeugungsraum zu besagtem anderen Element, das vom Hohlelement (5) getrennt ist, zu leiten
dabei ist das Gerät (2) **dadurch gekennzeichnet, dass** es einen Beschleunigungskanal (12) umfasst, welcher in Fluidverbindung mit besagtem Erzeugungsraum ist, und ein Druckregelungssystem (P), das konfiguriert ist, um vor dem Beschleunigungskanal (12) vorgelagert einen Druck aufzubauen, der größer ist als ein dem Beschleunigungskanal (12) nachgelagerter Druck, um im Einsatz sowohl im Erzeugungsraum als auch entlang dem Beschleunigungskanal (12) einen Gasstrom zu erzeugen, in einer Richtung von vorgelagert zu nachgelagert desselben Beschleunigungskanals (12), und wobei der Beschleunigungskanal (12) so konfiguriert ist, dass die Bewegung des besagten Gasstroms beschleunigt wird.

2. Das Gerät nach dem Patentanspruch 1, wobei der Beschleunigungskanal (12) eine Ausdehnungsachse hat und konfiguriert ist, um jegliche Komponenten mit Querbewegung der Gasmoleküle in eine Bewegung parallel zu derselben Achse zu verwandeln.

3. Das Gerät nach den Patentansprüchen 1 oder 2, wobei der Beschleunigungskanal (12) mindestens einen verjüngten Abschnitt (13) umfasst, der einen Querschnitt aufweist, welcher in der Richtung des Gasstroms abnimmt.

4. Das Gerät nach jedem der vorherigen Patentansprüche, wobei der Beschleunigungskanal (12) eine Lavaldüse umfasst.

5. Das Gerät nach jedem der vorherigen Patentansprüche, ebenfalls ein Interaktionselement (18) umfassend, welches vom Hohlelement (5) getrennt ist.

6. Das Gerät nach dem Patentanspruch 5, wobei besagtes anderes Element, das vom Hohlelement (5) getrennt ist, das Element der Interaktion (18) ist.

7. Das Gerät nach jedem der Patentansprüche 1 bis 5, wobei besagtes anderes Element, das vom Hohlelement (5) getrennt ist, das Ziel (3) ist.

8. Das Gerät nach jedem der vorherigen Patentansprüche, wobei der Erzeugungsraum besagten Hohlraum (6) umfasst.

9. Das Gerät nach dem Patentanspruch 3 und nach jedem der anderen vorherigen Patentansprüche, wobei das Hohlelement (5) eine Öffnung (11) umfasst, um den Hohlraum (6) in Fluidverbindung mit außen zu setzen; der Beschleunigungskanal (12) ist dabei zwischen dem getrennten Element und dem Hohlraum (6) positioniert und ist konfiguriert, um die Bewegung des Gasstroms durch die Öffnung (11) zu beschleunigen; das Druckregelungssystem (P) ist dabei so konfiguriert , dass es im Hohlraum (6) einen Druck aufbaut, der größer ist als derjenige außen; das andere Element, das vom Hohlelement (5) getrennt ist, ist dabei außerhalb des Hohlelements (5) positioniert; der verjüngte Abschnitt (13) verjüngt sich dabei in Richtung des anderen Elements, das vom Hohlelement (5) getrennt ist, und ist konfiguriert, um die Bewegung des Gasstroms in Richtung des anderen Elements, das vom Hohlelement (5) getrennt ist, zu beschleunigen.

10. Das Gerät nach jedem der vorherigen Patentansprüche, und das eine Auslösungselektrode (7) umfasst, welche zumindest teilweise im Hohlraum (6) platziert ist; die Aktivierungsgruppe (21) ist dabei ebenfalls konfiguriert, um einen Potentialunterschied zwischen der Auslösungselektrode (7) und dem Hohlelement (5) zu erzeugen, sodass sich innerhalb des Hohlraums (6) Elektronen bilden; im Einzelnen ist die Aktivierungsgruppe (21) elektrisch mit dem Hohlelement (5) verbunden und ist konfiguriert, um das elektrische Potential des Hohlelements (5) in weniger als 40 ns um mindestens 2 kV zu senken.

11. Das Gerät nach jedem der vorherigen Patentansprüche, wobei das Druckregelungssystem (P) eine Gasversorgungseinheit umfasst, die konfiguriert ist, um Gas in den Hohlraum (6) zuzuführen, um einen Druck im Hohlraum (6) zu halten, der größer ist als derjenige außen.

12. Das Gerät nach jedem der vorherigen Patentansprüche, und das ein Beschleunigungselement (23) umfasst, welches den Beschleunigungskanal (12) abgrenzt und direkt mit dem Hohlelement (5) verbunden ist.

13. Das Gerät nach jedem der vorherigen Patentansprüche von 1 bis 11, und das ein Beschleunigungselement (23) umfasst, welches den Beschleunigungskanal (12) abgrenzt und mit dem Hohlelement (5) durch ein Rohrelement (22) verbunden ist, das aus dielektrischem Material besteht, das zwischen sie zwischengeschaltet ist.

14. Das Gerät nach dem Patentanspruch 5 und jedem der anderen vorherigen Patentansprüche, wobei das Interaktionselement (18) einen Durchflusskanal (18a) umfasst, durch den der Elektronenstrahl im Einsatz durchfließt.

15. Das Gerät nach dem Patentanspruch 14, wobei der Durchflusskanal (18a) eine Einlassöffnung (25) umfasst, welche im Wesentlichen einer Auslassöffnung (26) des Beschleunigungskanals (12) gegenüberliegt.

16. Das Gerät nach dem Patentanspruch 15, wobei der Durchflusskanal (18a) und der Beschleunigungskanal (12) im Wesentlichen koaxial zueinander liegen.

17. Das Gerät nach den Patentansprüchen 14, 15 oder 16, wobei das Interaktionselement (18) eine innere Kammer (27) umfasst, welche in Fluidverbindung mit dem Durchflusskanal (18a) und seitlich abgegrenzt ist; die innere Kammer (27) umfasst dabei zwei offene Enden (29, 30) und erstreckt sich zwischen den offenen Enden (29, 30) quer in Bezug auf den Durchflusskanal (18a).

18. Das Gerät nach den Patentansprüchen 5 oder 6, **gekennzeichnet dadurch, dass** das Interaktionselement (18) einen Durchflusskanal (18a) umfasst, in dem der Elektronenstrahl im Einsatz durchfließt, und eine Einlassöffnung (25) umfasst, welche zum Hohlraum (6) gerichtet ist, um im Einsatz den Elektronenstrahl zu empfangen, und eine innere Kammer (27) in Fluidverbindung mit dem Durchflusskanal (18a) und seitlich abgegrenzt; die innere Kammer (27) umfasst dabei zwei offene Enden (29, 30) und erstreckt sich zwischen den offenen Enden (29, 30) quer in Bezug zum Durchflusskanal (18a).

19. Ein Apparat zur Ablagerung eines bestimmten Materials auf einem Träger (4), wobei der Apparat (1) Folgendes umfasst:
eine äußere Kammer (45), in die es im Einsatz möglich ist, besagten Träger (4),
auf dem die Ablagerung stattfindet, zu platzieren, und ein Ziel (3), das das vorbestimmte Material umfasst;
der Apparat (1) ist dabei **dadurch gekennzeichnet, dass** er ein Gerät (2; 2'; 2"; 2^{IV}; 2^{V}; 2^{VI}; 2^{V}"; 2^{VI}") umfasst, wie es in einem der vorherigen Patentansprüche definiert ist, der Hohlraum (6) des Geräts und die äußere Kammer (45) sind dabei in Verbindung miteinander; die äußere Kammer (45) enthält dabei Gas unter einem Druck, der weniger als 10⁻³ mbar beträgt; das Gerät (2; 2'; 2"; 2^{IV}; 2^{V}; 2^{VI}; 2^{VII} 2^{VIII}) ist dabei konfiguriert, um den Elektronenstrahl auf das Ziel (3) zu richten, sodass zumindest ein Teil des vorbestimmten Materials vom Ziel (3) entfernt und auf dem Träger (4) abgelagert wird.

20. Eine Methode zur Aufbringung eines vorbestimmten Materials auf einem Träger (4), wobei die Methode einen Emissionsschritt umfasst, während dem ein Gerät (2; 2'; 2"; 2^{IV}; 2^{V}; 2^{VI}; 2^{VII}; 2^{VIII}) nach jedem der Patentansprüche von 1 bis 18 besagten Elektronenstrahl auf ein Ziel (3) richtet, welches das vorbestimmte Material enthält, um zumindest einen Teil des vorbestimmten Materials vom Ziel (3) zu entfernen und auf den Träger (4) zu richten.

21. Eine Methode zur Erzeugung eines Elektronenstrahls, welche folgende Funktionsschritte umfasst:
einen Erzeugungsraum und einen Beschleunigungskanal (12), welcher damit verbunden ist, mit einem verdünnten, ionisierbaren Gas zu füllen;
einen Strom des besagten Gas durch den Erzeugungsraum und den Beschleunigungsraum (12) in Richtung nach außen zu erzeugen;
den Gasstrom auf einer Achse des Beschleunigungskanals (12) zu beschleunigen und jegliche Bewegungskomponenten der Gasmoleküle quer zur Achse in eine Bewegung zu verwandeln, die parallel zur selben Achse verläuft;
die Bildung von Plasma im Erzeugungsraum und zumindest teilweise im beschleunigten Gasstrom zu verursachen; und
den Elektronenstrahl von dem auf diese Weise gebildeten Plasma auf ein Ziel (3) zu richten.

22. Die Methode nach dem Patentanspruch 21, wobei der Gasstrom in Richtung zum Ziel (3) erzeugt wird.

23. Die Methode nach den Patentansprüchen 21 oder 22, wobei der beschleunigte Gasstrom verwendet wird, um das Plasma und den Elektronenstrahl zu leiten.

## Revendications

1. Un dispositif pour générer un plasma et diriger un faisceau d'électrons vers une cible (3) ; le dispositif (2) comprenant :
un élément creux (5), qui a une cavité (6) ;
un espace de génération dans lequel, pendant l'utilisation, le plasma est développé ;
un groupe d'activation (21), qui est configuré pour, pendant l'utilisation, imposer une différence de potentiel entre l'élément creux (5) et un autre élément qui est séparé de l'élément creux (5) de manière à diriger, pendant l'utilisation, le faisceau d'électrons de l'espace de génération vers ledit autre élément qui est séparé de l'élément creux (5),
le dispositif (2) étant **caractérisé en ce qu'**il comprend un canal d'accélération (12) en communication de fluide avec ledit espace de génération, et un système de régulation de pression (P), qui est configuré pour porter en amont du canal d'accélération (12) une pression supérieure à une pression en aval du canal d'accélération (12) pour, pendant l'utilisation, générer un flux de gaz à la fois dans l'espace de génération et le long du canal d'accélération (12) dans une direction d'amont en aval de ce même canal d'accélération (12), et le canal d'accélération (12) étant configuré pour accélérer le mouvement dudit flux de gaz.

2. Le dispositif selon la revendication 1, dans lequel le canal d'accélération (12) a un axe d'extension et est configuré pour transformer d'éventuelles composantes de mouvement transversal des molécules de gaz en un mouvement parallèle à l'axe lui-même.

3. Le dispositif selon la revendication 1 ou 2, dans lequel le canal d'accélération (12) comprend au moins une portion amincie (13) ayant une section qui décroît le long de la direction du flux de gaz.

4. Le dispositif selon l'une quelconque des revendications précédentes, dans lequel le canal d'accélération (12) comprend une tuyère de Laval.

5. Le dispositif selon l'une quelconque des revendications précédentes, comprenant aussi un élément d'interaction (18) qui est séparé de l'élément creux (5).

6. Le dispositif selon la revendication 5, dans lequel ledit autre élément qui est séparé de l'élément creux (5) est l'élément d'interaction (18).

7. Le dispositif selon l'une quelconque des revendications de 1 à 5, dans lequel ledit autre élément qui est séparé de l'élément creux (5) est la cible (3).

8. Le dispositif selon l'une quelconque des revendications précédentes, dans lequel l'espace de génération comprend ladite cavité (6).

9. Le dispositif selon la revendication 3 et l'une quelconque des autres revendications précédentes, dans lequel l'élément creux (5) comprend une ouverture (11), pour mettre en communication de fluide la cavité (6) avec l'extérieur; le canal d'accélération (12) étant positionné entre l'élément séparé et la cavité (6), et étant configuré pour accélérer le mouvement du flux de gaz à travers l'ouverture (11) ; le système de régulation de pression (P) étant configuré pour porter dans la cavité (6) une pression supérieure à celle de l'extérieur ; l'autre élément qui est séparé de l'élément creux (5) étant positionné à l'extérieur de l'élément creux (5) ; la portion amincie (13) étant amincie vers l'autre élément qui est séparé de l'élément creux (5) et étant configurée pour accélérer le mouvement du flux de gaz vers l'autre élément qui est séparé de l'élément creux (5).

10. Le dispositif selon l'une quelconque des revendications précédentes, et comprenant une électrode de déclenchement (7), qui est au moins partiellement placée à l'intérieur de la cavité (6) ; le groupe d'activation (21) étant également configuré pour imposer une différence de potentiel entre l'électrode de déclenchement (7) et l'élément creux (5) de manière à ce que des électrons se forment à l'intérieur de la cavité (6) ; en particulier, le groupe d'activation (21) est électriquement relié à l'élément creux (5) et est configuré pour réduire le potentiel électrique de l'élément creux (5) d'au moins 2kV en moins de 40ns.

11. Le dispositif selon l'une quelconque des revendications précédentes, dans lequel le système de régulation de pression (P) comprend une unité d'alimentation de gaz, configurée pour alimenter du gaz dans la cavité (6) pour maintenir à l'intérieur de ladite cavité (6) une pression qui est supérieure à celle de l'extérieur.

12. Le dispositif selon l'une quelconque des revendications précédentes, et comprenant un élément d'accélération (23), qui délimite le canal d'accélération (12) et est directement raccordé à l'élément creux (5).

13. Le dispositif selon l'une quelconque des revendications de 1 à 11, et comprenant un élément d'accélération (23), qui délimite le canal d'accélération (12) et est raccordé à l'élément creux (5) au moyen d'un élément tubulaire (22), réalisé en matériau diélectrique, interposé entre eux.

14. Le dispositif selon la revendication 5 et l'une quelconque des autres revendications précédentes, dans lequel l'élément d'interaction (18) comprend un canal de passage (18a), à l'intérieur duquel, pendant l'utilisation, le faisceau d'électrons passe.

15. Le dispositif selon la revendication 14, dans lequel le canal de passage (18a) comprend une extrémité d'entrée (25) essentiellement en face d'une extrémité de sortie (26) du canal d'accélération (12).

16. Le dispositif selon la revendication 15, dans lequel le canal de passage (18a) et le canal d'accélération (12) sont essentiellement coaxiaux entre eux.

17. Le dispositif selon la revendication 14, 15 ou 16, dans lequel l'élément d'interaction (18) comprend une chambre intérieure (27) en communication de fluide avec le canal de passage (18a) et délimitée latéralement ; la chambre intérieure (27) comprenant deux extrémités ouvertes (29, 30) et s'étendant entre lesdites extrémités ouvertes (29, 30) transversalement par rapport au canal de passage (18a).

18. Le dispositif selon la revendication 5 ou 6, **caractérisé en ce que** l'élément d'interaction (18) comprend un canal de passage (18a), à l'intérieur duquel, pendant l'utilisation, le faisceau d'électrons passe et comprenant une extrémité d'entrée (25) orientée vers la cavité (6) pour, pendant l'utilisation, recevoir le faisceau d'électrons, et une chambre intérieure (27) en communication de fluide avec le canal de passage (18a) et délimitée latéralement ; la chambre intérieure (27) comprenant deux extrémités ouvertes (29, 30) et s'étendant entre lesdites extrémités ouvertes (29, 30) transversalement par rapport au canal de passage (18a).

19. Un appareil pour déposer un matériau prédéfini sur un support (4), l'appareil (1) comprenant :
une chambre extérieure (45) dans laquelle, pendant l'utilisation, il est possible de placer ledit support (4), sur lequel le dépôt a lieu, et une cible (3) comprenant le matériau prédéfini ;
l'appareil (1) étant **caractérisé en ce qu'**il comprend un dispositif (2 ; 2' ; 2" ; 2^{IV}; 2^{V}; 2^{VI}; 2^{VII} ; 2^{VIII}) tel que défini dans l'une des revendications précédentes, la cavité (6) du dispositif et la chambre extérieure (45) étant en communication l'une avec l'autre ; la chambre extérieure (45) contenant du gaz à une pression inférieure à 10⁻³ mbars ; le dispositif (2 ; 2' ; 2" ; 2^{IV} ; 2^{V} ; 2^{VI} ; 2^{VII ;} 2^{VIII}) étant configuré pour diriger le faisceau d'électrons contre la cible (3) de manière à ce qu'au moins une partie du matériau prédéfini soit enlevée de la cible (3) et soit déposée sur le support (4).

20. Un procédé pour l'application d'un matériau prédéfini sur un support (4), le procédé comprenant une phase d'émission, pendant laquelle un dispositif (2 ; 2' ; 2" ; 2^{IV} ; 2^{V}; 2^{VI} ; 2^{VII} ; 2^{VIII}) selon l'une quelconque des revendications de 1 à 18 dirige ledit faisceau d'électrons contre une cible (3) comprenant le matériau prédéfini de manière à enlever au moins une partie du matériau prédéfini de la cible (3) et à le diriger vers le support (4).

21. Un procédé pour générer un faisceau d'électrons comprenant les phases opérationnelles consistant à :
remplir un espace de génération et un canal d'accélération (12) qui communique avec lui avec un gaz ionisable raréfié ;
générer un flux dudit gaz à travers l'espace de génération et le canal d'accélération (12), et vers l'extérieur ;
accélérer le flux de gaz le long d'un axe du canal d'accélération (12) et transformer d'éventuelles composantes de mouvement des molécules de gaz transversales à l'axe en un mouvement parallèle à l'axe lui-même ;
causer la formation de plasma dans l'espace de génération et au moins partiellement dans le flux de gaz accéléré ; et
diriger le faisceau d'électrons du plasma ainsi formé vers une cible (3).

22. Le procédé selon la revendication 21, dans lequel le flux de gaz est généré dans la direction allant vers la cible (3).

23. Le procédé selon la revendication 21 ou 22, dans lequel le flux de gaz accéléré est utilisé pour guider le plasma et le faisceau d'électrons.
